(19) Europäisches Patentamt
European Patent Office
Office européen des brevets

(11) Veröffentlichungsnummer: **0 379 856**
**A2**

(12) # EUROPÄISCHE PATENTANMELDUNG

(21) Anmeldenummer: **90100066.1**

(22) Anmeldetag: **03.01.90**

(51) Int. Cl.5: **C23C 18/16, C08L 81/02, //(C08L81/02,69:00,71:00,77:00, 67:00,21:00)**

(30) Priorität: **14.01.89 DE 3901029**

(43) Veröffentlichungstag der Anmeldung:
**01.08.90 Patentblatt 90/31**

(84) Benannte Vertragsstaaten:
**BE DE ES FR GB IT NL**

(71) Anmelder: **BAYER AG**

**D-5090 Leverkusen 1 Bayerwerk(DE)**

(72) Erfinder: **Sirinyan, Kirkor, Dr.**
**Humperdinckstrasse 12**
**D-5060 Bergisch Gladbach 2(DE)**
Erfinder: **Köhler, Karl-Heinz, Dr.**
**Buschstrasse 165**
**D-4150 Krefeld 1(DE)**
Erfinder: **Reinking, Klaus, Dr.**
**Robert-Stolz-Strasse 16b**
**D-5632 Wermelskirchen 1(DE)**
Erfinder: **Rüsseler, Wolfgang, Dr.**
**Waldhofstrasse 121**
**D-4150 Krefeld(DE)**
Erfinder: **Wehnert, Wolfgang, Dr.**
**Bodelschwinghstrasse 14**
**D-4150 Krefeld(DE)**

(54) **Verfahren zum Metallisieren von Formkörpern aus Polyarylensulfiden.**

(57) Leiterplatten mit hervorragenden elektrischen und mechanischen Eigenschaften erhält man, wenn man als Basisplatten für die naßchemische Abscheidung des Leiterbildes spezielle Mischungen aus Polyarylensulfiden und Polycarbonaten, Polyarylethern, Polyamiden, Polyestaern oder Kautschukelastomeren verwendet und die Platten vor der Aktivierung mit einem Oxidationsmittel behandelt.

EP 0 379 856 A2

## Verfahren zum Metallisieren von Formkörpern aus Polyarylensulfiden

Gegenstand der Erfindung ist ein Verfahren zum naßchemischen Metallisieren von modifizierten Polyarylensulfiden sowie die Verwendung der Verfahrensprodukte zum Aufbau von elektrischen Leiterplatten.

Wegen der bekanntermaßen hervorragenden thermischen, mechanischen und dielektrischen Eigenschaften der Polyarylensulfide - ganz allgemein - sind bereits zahlreiche Versuche unternommen worden, diese Polymeren durch geeignete Vorhandlungsmaßnahmen für die naßchemische Metallisierung einsatzfähig zu machen.

Die zahlreichen vorbekannten Verfahren weisen jedoch durchweg diverse Mängel auf, indem sie zu aufwendig sind und/oder zu geringe Haftfestigkeiten der Metallbeschichtungen ergeben.

Es wurde nun gefunden, daß man auf relativ einfache Weise zu gut haftenden Metallauflagen gelangt, wenn die Formkörper aus solchen Polyarylensulfiden bestehen, die

a) 3 - 40% Polycarbonat oder Polyarylether,

b) 2,5 - 15% Polyamid oder Polyester,

c) 2 - 20% eines Kautschukelastomeren - jeweils bezogen auf das Gesamtgewicht der Polymermischung -enthalten.

Die Besonderheit des neuen Verfahrens besteht darin, daß es ohne die sonst üblichen physikalischen Vorbehandlungsmethoden, wie Einwirkung energiereicher Strahlung und mechanische Aufrauhung zum gewünschten Ergebnis führt.

Es reicht aus, wenn man auf die Oberflächen der Formkörper kurzzeitig ein Glas nichtätzendes Oxidationsmittel einwirken läßt.

Geeignete Polyarylensulfide zur Herstellung der Polymermischungen sind insbesondere Polyphenylensulfide, wie sie in der oben abgehandelten und nachstehend zitierten Patentliteratur beschrieben sind: US-A 2 513 188, US-A 2 538 941, US-A 3 291 779, vorzugsweise US-A 3 354 129, US-A 4 038 261, USA 4 038 259, US-A 4 038 263, US-A 4 038 262, US-A 4 046 114, US-A 4 038 260, US-A 4 116 949, EP-A 56 690, EP-A 119 607 und EP-A 171 021.

Man erhält diese Polymeren nach an sich bekannten Methoden, insbesondere durch Umsetzung von di- oder polychlorierten Aromaten mit $Na_2S$ in hochsiedenden Lösungsmitteln.

Beispielhaft seien folgende Polymeren genannt: Poly-2,4-tolylen-sulfid, Poly-phenylensulfid, Poly-4,4-biphenylensulfid bzw. deren teilverzweigte und/oder vernetzte Typen (vgl. beispielsweise US-Patent 3 324 087) bzw. deren Cokondensate mit mono-, di- oder poly-Chlorbenzolsulfonsäure, -benzoesäure usw.. Das letztgenannte wird zur Durchführung des Verfahrens besonders bevorzugt eingesetzt.

Die als Mischungskomponente eingesetzten Polycarbonate sind ebenfalls bekannte Verbindungen und haben wiederkehrende Einheiten der nachstehend allgemeinen Formel (I)

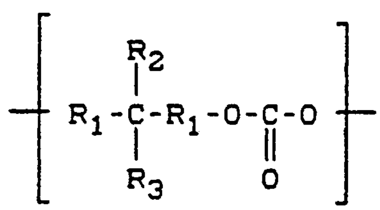

(I)

in welcher jeder Baustein $-R_1-$ aus der Gruppe, bestehend aus Phenylen und/oder halogensubstituiertem Phenylen und/oder alkylsubstituiertem Phenylen ausgewählt ist und die Reste $R_2$ und $R_3$ aus der Gruppe, bestehend aus Wasserstoff, gesättigten und ungesättigten Kohlenwasserstoffen, ausgewählt werden können, wobei die Anzahl der Kohlenstoffatome bis zu 8 betragen. Beispielsweise seien genannt: $-CH_3$, $-C_2H_5$ und $-C_3H_7$.

Erfindungsgemäß können Polymere auf Basis von beliebigen aromatischen Polycarbonaten verwendet werden. Jedoch sind Polycarbonate, die durch Umsetzen von Bisphenol-A (2,2-Bis(4-hydroxyphenyl)-propan hergestellt werden, besonders geeignet. Ferner können Polycarbonate, die auf Basis von Bis(4-hydroxyphenyl)-methan, 2,2-Bis(4-hydroxyphenyl)-propan, 2,2-Bis(4-hydroxy-3-methylphenyl)-propan, 3,3′-Dichlor-4,4′-dihydroxydiphenyl)-methan hergestellt werden, eingesetzt werden.

Die Herstellung dieser Polycarbonate können der Patentliteratur (vgl. beispielsweise US-A 3 028 365 und US A 3 275 601) entnommen werden. Die zur Herstellung der Polycarbonate verwendeten Carbonyldihalogenide, wie Carbonyldichlorid, Carbonatester oder Halogenformiate sind allgemein bekannt. Selbstverständlich können die Polycarbonate auch in Gegenwart von Säureakzeptoren, Molekulargewichtsreglern und Katalysatoren hergestellt werden.

Bevorzugte einzusetzende Polymermischungen a) enthalten 4 - 20%; insbesondere 5 - 10% an Polycarbonat bzw. Polyether.

Weiterhin sind Co- und Mischkondensate der aromatischen Polycarbonate mit Polysiloxanen sehr gut geeignet. Diese Polymerisate können eine Polysiloxankomponente in Mengen von 1 bis 40 Gew.-% enthalten, wobei die Mengen 2,5-15 Gew.-% bevorzugt und die 2,5-10 Gew.-% besonders bevorzugt werden. Solche Misch- und Co-Kondensate sind Stand der Technik.

Die vorstehend genannten Polysiloxane haben vornehmlich wiederkehrende Einheiten der allgemeinen Formel (II)

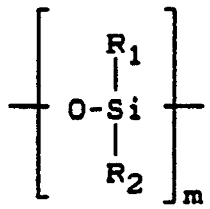

(II)

in welcher jeder Baustein mit den Resten $R_1$ und $R_2$ aus der Gruppe, bestehend aus Wasserstoff, gesättigten und/oder ungesättigten Kohlenwasserstoffen mit Kohlenwasserstoffatomen 1-8 wie $-CH_3$, $-C_2H_5$ und $-C_3H_7$ ausgewählt werden können. Bevorzugtes Polymeres ist Polydimethylsiloxan.

Ferner können die Siliziumatome halogensubstituierte und halogenfreie bzw. alkylsubstituierte Phenylgruppen enthalten. In diesem Zusammenhang seien auch Polysiloxanpolymerisate, die aus Phenyltrichlorsilan hergestellt werden, genannt.

Diese Polysiloxane können beispielsweise durch Reaktion von chlorierten Silanen, wie Dichlorsilanen, mit Wasser und Kondensation der entstandenen - im monomeren Zustand - nicht isolierbaren Dialkylkieselsäuren untereinander und mit Alkylchlorsilanen hergestellt werden.

Selbstverständlich kann ihre Herstellung aus cyclischen Organosiliziumverbindungen, wie Trisiloxan-6-Ring oder Tetrasiloxan-8-Ring in Gegenwart einer Base, wie KOH als Initiator vorgenommen werden. Die besagten Siloxane können Reste aufweisen, deren Kohlenstoffkette durch eine oder mehrere funktionelle Gruppen, wie Sauerstoffatome unterbrochen sein können. Solche Siloxane sind ebenfalls bekannt und beispielsweise in

DE-A 2 543 638, US-A 4 076 695,
US-A 4 472 341 und DE-A 3 600 102

beschrieben.

Vorzugsweise werden folgende Polyarylethertypen eingesetzt:

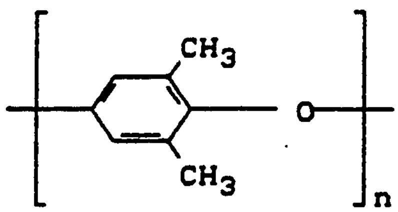

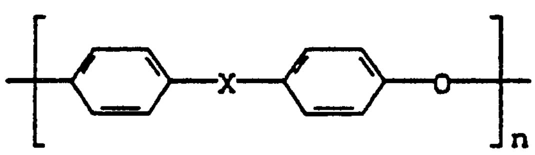

$X = SO_2$

$X = C=O$

sowie

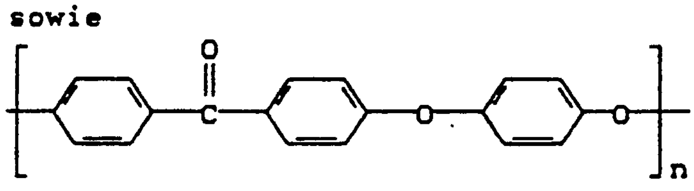

Selbstverständlich können auch die Mischungen bzw. Cokondensate der besagten Polyarylether eingesetzt werden.

Die als Mischungskomponente eingesetzten Polyamide sind ebenfalls bekannte Verbindungen und sind insbesondere handelsübliche Typen, wie Polyamid-6, Polyamid-6.6, Polyamid-10, Polyamid-11 und Polyamid-12 sowie deren Mischungen. Weitere geeignete Polyamide sind thermoplastische Polyamid-imide.

Ferner sind schlagzähmodifizierte handelsübliche kautschukhaltige Polyamidtypen, vorzugsweise auf Basis von PA-6 und PA-6,6, zur Durchführung des erfindungsgemäßen Verfahrens gut geeignet.

Die Menge des Polyamids in der Kunststoffmatrix beträgt vorzugsweise 5 bis 10 Gew.-%.

Die als Mischkomponenten eingesetzten Polyester zur Durchführung können bekannterweise durch Polykondensation aus aliphatischen bzw. aromatischen Dicarbonsäuren und/oder aromatischen bzw. aliphatischen Diolen oder aromatischen bzw. aliphatischen Hydroxycarbonsäuren hergestellt werden.

In diesem Zusammenhang seien als aromatische Dicarbonsäuren Terephthalsäure, Isophthalsäure, 4,4′-Dicarboxydiphenyl, 2,6-Dicarboxynaphthalen, 1,2- bis (4-carboxyphenoxy)ethan bzw. deren alkyl- Aryl-, Alkoxy- und Halogensubstituenten genannt.

Als aromatische Diole seien Hydrochinone, Resorcinol, 4,4′-Dihydroxydiphenyl, 4,4′-Dihydroxybenzophenon, 4,4′-Dihydroxydiphenylmethan, 4,4′-Dihydroxydiphenylethan, 2,2-bis(4-hydroxy-phenyl)-propan, 4,4′-Dihydroxydiphenylether, 4,4′-Dihydroxydiphenylsulphon, 4,4′-dihydroxydephenylsulphid, 2,6-Dihydroxynaphthalen, 1,5-Dihydroxynaphthalen und deren alkyl-, Aryl-, Alkoxy- oder Halogen-Derivate erwähnt.

Als aromatische Hydroxycarbonsäuren kommen p-Hydroxybenzoesäure, m-Hydroxybenzoesäure, 2-Hydroxynaphthalen-6-carbonsäure, 1-Hydroxynaphthalen-5-carbonsäure und deren Alkyl-, Aryl-, Alkoxy- oder Halogensubstituenten in Betracht.

Die besagten aliphatischen Polyester der vorliegenden Erfindung haben wiederkehrende Einheiten der Formel (I)

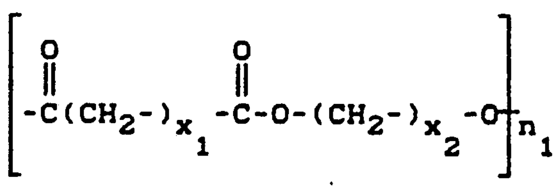

(I)

wobei $x_1$ und $x_2$ 1 bis 12, vorzugsweise 3 bis 6, besonders bevorzugt 4 bis 6 sind.

Zur Herstellung der zu verwendenden Blends können ebenso Polyestercarbonate der allgemeinen Formel (II)

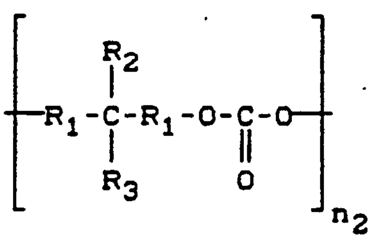

(II)

worin

$R_1$ ggf. durch Chlor oder $C_1$-$C_4$-Alkyl substituiertes Phenylen und

$R_2$, $R_3$ H oder $C_1$-$C_8$-Alkyl bedeuten.

Der bevorzugte Gewichtsanteil der Polyester in den Polymermischungen beträgt 5 bis 10 %.

Die als Mischungskomponente eingesetzten Kautschuke sind bekannte Polymerisate, z.B. solche, die eine $T_G$ (Glasumwandlungstemperatur) $\leq 5\,^\circ C$, insbesondere $\leq -20\,^\circ C$, aufweisen.

In diesem Zusammenhang sei auf Polyisopren, Polybutadien bzw. auf deren 1,2 - und/oder 1,4 cis-bzw. trans-Isomere hingewiesen.

Ferner sind Kautschuktypen auf Basis von 1,5-Hexadien, Isobuten und Dimethylsiloxan bzw. deren Mischungen untereinander geeignet.

Auch Pfropf-, Co- und Mischpolymerisate der besagten Kautschuke untereinander, ferner solche mit Acrylnitril, Styrol und Acrylsäureester, kommen in Betracht.

Die besagten Pfropf- und Copolymerisate sind bekannte Produkte und beispielsweise in "Kunststoff-Handbuch, IV, R. Vieweg et al., Seiten 122-145, Carl Hanser Verlag (1969) München" beschrieben.

Darüber hinaus können die besagten Kautschuktypen mit polaren Monomeren, wie Maleinsäureanhydrid oder Methacrylsäuremethylester gepfropft bzw. mit $Fe^{2+}/M_2O$, Perfluoressigsäure/$H_2O_2$, Peroxoessigsäure oxidativ vorbehandelt und dadurch mit polaren Gruppen (z.B. OH oder COOH) versehen werden.

Besonders bevorzugte Mischungskomponenten sind die halogenmodifizierten, vorzugsweise fluorhaltigen Typen. In diesem Zusammenhang sei erwähnt, daß die Fluormenge, bezogen auf das eingesetzte Kautschuk, nicht größer als 20 Gew.-%, vorzugsweise 10 Gew.-%, betragen kann

Ferner sind Spezialtypen der besagten Co-Pfropf- und Mischpolymerisate, die übliche ultraviolettlichtabschirmende oder absorbierende Verbindungen, wie Cyasorb 5411, ein Benzotriazol-Ultraviolettlichtabsorber der Fa. American Cyanamid oder Sanduvor VSU, ein Oxamid-Ultraviolettlichtabsorber der Fa. Sandoz und darüber hinaus auch übliche Pigmente, Farbstoffe, Formtrennmittel und Gleitmittel, wie Alkali- und Erdalkalisteasate enthalten, sehr gut geeignet.

Bevorzugt einzusetzende Polymermischungen c) enthalten 3 bis 10 % Kautschukelastomere.

Die besagten Polyphenylensulfidblends weisen überraschenderweise geringe Wasseraufnahme auf. Diese gute Eigenschaft wird überraschenderweise weder durch die oxidative Vorbehandlung noch durch die Sensibilisierung bzw. Aktivierung negativ beeinflußt.

Eine weitere Verbesserung der Metallhaftung kann erzielt werden, wenn man die Polymermischungen zusätzlich mit anorganischen nicht wasserlöslichen, elektrisch isolierenden Füllstoffen versetzt. Unter nicht wasserlöslich soll eine Löslichkeit $\leqq$ 4,5, vorzugsweise $\leqq$ 3,5, besonders bevorzugt $\leqq$ 0,25 g, (Füllstoff)/1000 g ($H_2O$) verstanden werden.

Zur Durchführung des Verfahrens gut geeigneter PPS-Füllstoffe sind Metallsalze, Metalloxide und mineralische Füllstoffe, außer C-Faser, Kevlar, Aramid, Glas und Quarz. Sie können eine durchschnittliche Partikelgröße von 0,01 bis 50 $\mu$m, vorzugsweise 1,0 bis 8,0 $\mu$m, besonders bevorzugt 2 bis 3 $\mu$m aufweisen. Gewöhnlich macht der Füllstoff etwa 1 bis 90 Gew.-%, vorzugsweise jedoch 7,5 bis 40 Gew.-%, besonders bevorzugt 10 bis 30 Gew.-%, des Gesamtgewichtes von PPS und Füllstoff aus.

Zur Durchführung des Verfahrens gut geeigneter Metallsalze sind Carbonate Nitrate, Nitrite, Sulfide, Sulfite, Sulfate, Hydroxide, Halogenide in verschiedenen Oxidationsstufen der Elemente Barium, Wismuth, Silber, Cadmium, Kobalt, Kupfer, Nickel, Blei, Zinn, Magnesium, Mangan, Eisen und Zink. Ferner können Acetate, Orthophosphate, Pyrophosphate oder Rodanite der o.a. Elemente zur Durchführung des Verfahrens eingesetzt werden.

Besonders gut geeignete Füllstoffe sind CuS, NiS, $BaSO_4$, $TiO_2$, $BaF_2$, $BaJO_3$, $Cd(OH)_2$, $FeCO_3$, $Fe(OH)_2$, $Fe(OH)_3$, $Co(OH)_2$, $CuCN_2$, AgCl, $MgCl_2$, $Mg_2P_2O_7$ bzw. deren Mischungen untereinander. Oxide der Metalle, Aluminium, Artinon, Wismuth, Cer, Kobalt, Kupfer, Gallium, Mangan, Mangnesium, Germanium, Indium, Eisen, Blei, Nickel, Zinn, Zink können zur Durchführung des Verfahrens ebenso eingesetzt werden. In diesem Zusammenhang sei auf $SiO_2$, $Al_2O_3$, MnO, $MnO_2$, MgO, BaO hingewiesen.

Geeignete Oxidationsmittel zur Durchführung des erfindungsgemäßen Verfahrens sind vorzugsweise 2 %ige wäßrige $Br_2$-Lösungen, konz. $H_2SO_4$ (Dichte = 1,84 g/cm$^3$ ) oder Chromschwefelsäure, bestehend aus beispielsweise 0,1-30 g/l $Na_2Cr_2O_7$ oder bestehend aus beispielsweise 0,1-40 g/l $Na_2Cr_2O_7$, 200 ml $H_2O_{dest.}$, 600 ml $H_2SO_{4konz.}$ und 200 ml $H_3PO_{4konz.}$ oder organische Persäuren, wie

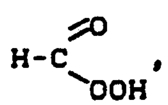 , 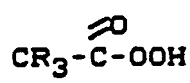

R = H, Cl, Br, J und vorzugsweise F oder Peroxobenzolsufonsäure, Benzolsulfonsäure und $H_2O_2$ oder $H_2O_2$ in Hexafluor- oder Trifluoraceton.

Die Behandlung kann in einem Temperaturbereich von -15 °C bis zum jeweiligen Siedepunkt des besagten Oxidationsmediums, vorzugsweise jedoch in einem Bereich van +15 bis +60 °C und ganz besonders bevorzugt in einem Bereich von +15 °C bis +40 °C im Verlaufe von 0,5 bis 90 Minuten, vorzugsweise jedoch 1 bis 10 Minuten, besonders bevorzugt 5 bis 7 Minuten, erfolgen.

Mit Hilfe der nach dem erfindungsgemäßen Verfahren abgeschiedenen Metallauflagen können spritzgegossene Leiterplatten sowohl nach bekanntem Semi-Additiv- als auch Voll-Additiv-Verfahren hergestellt werden.

Zur Herstellung von Leiterplatten nach dem Voll-Additiv-Verfahren werden die Formkörper gegebenenfalls mit Löchern versehen, mit den besagten Oxidationsmitteln behandelt, aktiviert, gegebenenfalls sensibilisiert, anschließend mit einer Maske auf der Basis von Siebdruckpasten oder Photolacken versehen und dann auf die maskenfreien Stellen auf naßchemischem Wege eine Metallauflage der Schichtdicke 5 bis 40

µm abgeschieden.

Bei der technischen Durchführung des Verfahrens kann selbstverständlich die Reihenfolge des Maskierungsschrittes - ob vor oder nach dem Aktivieren oder Sensibilisieren - beliebig variiert werden. In diesem Zusammenhang sei erwähnt, daß durch die oxidative Behandlung und gegebenenfalls durch eine anschließende Temperung die Haftung der Metallauflage überraschenderweise erheblich verbessert wird.

Bevorzugte Metallauflagen sind Kupferbeschichtungen.

Zur Herstellung von Leiterplatten nach dem Semi-Additiv-Verfahren werden die Formkörper gegebenenfalls mit Löchern versehen, nach dem bereits beschriebenen Verfahren mit einer durchgehenden Metallauflage der Schichtdicke 0,1 bis 10 µm vorzugsweise 0,5 bis 2,0 µm, metallisiert, anschließend - wie bereits angegeben - mit einer Maske auf Siebdrucklack- oder Photolackbasis versehen, die maskenfreien Stellen auf 12 bis 70 µm, vorzugsweise jedoch auf 17,5 bis 40 µm, verstärkt, die Maske chemisch oder mechanisch von der Oberfläche entfernt und dann die elektrisch leitende Metallauflage vorzugsweise durch Differenzätzen von der Probenoberfläche entfernt. Zur galvanischen Verstärkung können übliche Metalle wie Ni, Cu, Co, Ag und Au bzw. deren Mischungen untereinander eingesetzt werden. Das bevorzugte Metall ist Kupfer.

Die vor der Metallisierung vorzunehmende Aktivierung erfolgt - gegebenenfalls nach einer "Entgiftung" mit z.B. einer Bisulfitlösung - mit üblichen kolloidalen oder ionogenen Aktivierungssystemen, vorzugsweise auf der Basis von Palladium.

Besonders geeignet als Aktivatoren sind darüber hinaus metallorganische Komplexverbindungen von Edelmetallen, wie sie z.B. in EP-A 81 129 und 82 438 sowie in US-A 4 636 441 und 4 006 047 sowie in DE-A 2 116 389 und 2 451 217 beschrieben sind. Bevorzugt sind Pd-Komplexe.

An die Aktivierung kann sich gewünschtenfalls eine Sensibilisierung mittels $SnCl_2$- oder $ZnCl_2$-Lösungen anschließen.

Für die Metallisierung kommen die in der Literatur ausführlich beschriebenen und vor allem die im Handel erhältlichen Bäder in Betracht. Nach der Metallisierung empfiehlt sich häufig eine Temperung im Bereich zwischen Glasumwandlungstemperatur und Erweichungspunkt, d.h. zwischen etwa 90 und 250 °C, vorzugsweise 120 und 170 °C. Die Temperungszeit kann breit variiert werden und beträgt vorzugsweise 40 bis 80 Minuten.

Die erfindungsgemäß erhältlichen Metall-Verbundwerkstoffe weisen eine Metallauflage nach DIN 53 496 von mindestens 10 N/inch, üblicherweise 15-30 N/inch, in Sonderfällen 35 bis 60 N/inch auf. Diese Werkstoffe zeichnen sich durch ihre gute Wärmeleitfähigkeit und hervorragende Abschirmung gegenüber den elektromagnetischen Störwellen aus. Sie können sowohl im Automobilsektor als auch im Elektro- und Elektronikbereich eingesetzt werden.

Besonders bevorzugt ist die Anwendung des neuen Verfahrens zur Herstellung von Feinstleiterplatten mit Bahnbreiten ≦ 200 µm nach der Differenzätzmethode.

In den nachfolgenden Beispielen bedeutet "PPS" Polyphenylensulfid und "PA" Polyamid.

<u>Beispiel 1 a</u>

Eine spritzgegossene PPS/PC-Platte (95 % PPS mit 5 Polycarbonat) (150 x 150 x 2 mm) wird in einem Bad bestehend aus
8,5 g $Na_2Cr_2O_7$ und 100 ml $H_2SO_4$ ($\rho$ 1;84 g/cm³) bei RT 5 Min. vorbehandelt, mit $H_2O_{dest.}$ gewaschen, getrocknet, in einer Lösung bestehend aus 0,5 g Mesityloxidpalladiumchlorid 1000 ml $CCl_2 = CCl_2$ bei RT 5 Min. aktiviert, getrocknet, in einer Lösung bestehend aus 1,0 g NaOH, 8,0 g DMAB (Dimethylaminboran) 1000 ml $H_2O_{dest.}$ sensibilisiert, mit $H_2O_{dest.}$ gewaschen und dann in einem Ni-Bad der Schering AG, 1000 Berlin, im Verlaufe von 30 Min. mit einer Ni-Auflage versehen. Anschließend wird diese Platte bei 150 °C 1h getempert.

Man bekommt einen Verbundwerkstoff mit guter Metallhaftung. Die Haftfestigkeit der Metallauflage, bestimmt durch die Abzugskraft nach DIN 53 496, beträgt ≧ 30 N/25 mm.

Die galvanische Verstärkung von der o.a. PPS-Platte für die Bestimmung der Abzugskraft wurde wie folgt durchgeführt:

a) eine halbe Minute dekapieren in 10 %iger $H_2SO_4$
b) Spülen
c) 5 Minuten im Halbglanznickelbad, Spannung 3 Volt, Badtemperatur 60 °C
d) Spülen
e) eine halbe Minute dekapieren,
f) 90 Minuten im Kupferbad, Spannung 1,3 Volt, Badtemperatur 28 °C

g) Spülen.

Die Metallauflage besteht den Lötbadtest.

Die so hergestellte Platte wird mit einer partiellen Maske (Siebdruckverfahren) versehen, die maskenfreien Stellen auf galvanischem Wege auf 40 $\mu m$ verstärkt, die Maske in $CH_2Cl_2$ von der PPS-Oberfläche entfernt und dann die restliche Ni-Auflage in einem Bad bestehend aus

3 g $FeCl_2$

15 ml HCl

500 ml $H_2O_{dest.}$

durch Differenzätzen von der Oberfläche entfernt. Man bekommt eine spritzgegossene Leiterplatte mit hervorragenden elektrischen und thermischen Eigenschaften.

Beispiel 2a

Eine im Beispiel 1a angegebene PPS-Platte wird in einer Lösung bestehend aus

$$250 \text{ ml } CF_3-\overset{\overset{O}{\|}}{C}-O-OH$$

$$100 \text{ ml } H_2O_{dest.}$$

bei RT im Verlaufe von 5 Minuten vorbehandelt, mit $H_2O_{dest.}$ gewaschen in einem Bad bestehend aus

1,0 g Bisbenzonitrilpalladiumdichlorid

1000 ml $CH_3-\underset{\underset{O}{\|}}{C}-CH_3$

aktiviert, getrocknet und dann nach Beispiel 1 sensibilisiert.

Anschließend wird die Platte in einem handelsüblichen Cu-Bad der Shiplay AG, D-7000 Stuttgart, im Verlaufe von 50 Minuten verkupfert und nach Beispiel 1 mit Hilfe eines Photoresists der Fa. BASF AG, nach dem Differenzverfahren mit Leiterbahnen versehen. Die anschließend bei 170 °C getemperte Platte weist eine Metallhaftung von ≧ 30 N/inch auf. Die Metallauflage haftet auf der PPS-Oberfläche so gut, daß sie den Lötbadtest besteht.

Die Kriechstromfestigkeit ist gut.

Beispiel 3 a

Eine 15 % glasfaserverstärkte PPS/PC-Platte (PPS-Anteil 80 %), die noch zusätzlich MgO 10 % enthält, wird in einer Lösung bestehend aus

5 g $CrO_3$

1000 ml $H_2SO_4$ ($\rho$ = 1,84 g/$cm^3$)

5 Minuten bei 80 °C vorbehandelt,

in einem kolloidalen Aktivator der Fa. Blasberg AG, in D-5650 Solingen, aktiviert und dann nach Beispiel 2 metallisiert bzw. mit Leiterbahnen versehen. Man bekommt eine Leiterplatte mit guter Metallhaftung (≧ 17,5 N/inch). Die Leiterbahnen bestehen den Lötbadtest und die Platte zeigt eine gute Kriechstromfestigkeit.

Beispiel 4 a

Eine 20 % glasfaserverstärkte PPS/PC-Platte (93 % PPS) wird in einem Bad bestehen aus

2 g $Br_2$

1000 ml $H_2O_{dest.}$

vorbehandelt, gewaschen und dann mit einem ionogenen Aktivator bestehend aus

1 g $PdCl_2$

10 g HCl (37 %ig)

1000 ml $H_2O_{dest.}$

aktiviert, nach Beispiel 1 sensibilisiert. Diese Platte wird anschließend mit einer partiellen Maske (Siebdruckverfahren) versehen, in einem chemischen Metallisierungsbad mit 15 $\mu m$ Cu-Auflage versehen

und anschließend bei 160 °C 1 Stunde getempert.

Man bekommt eine nach dem Volladditivverfahren hergestellte Leiterplatte mit einer guten Metallhaftfestigkeit. Diese Leiterplatte läßt sich in gängigen Lötbädern bei etwa 260 °C löten.

Beispiel 5 a

Eine Leiterplatte nach Beispiel 1 a wird in einem Bad bestehend aus
5 g $Na_2Cr_2O_7$
600 g $H_2SO_{4konz.}$
150 g $H_3PO_{4konz.}$
vorbehandelt, gewaschen und getrocknet mit einer Aktivierungslösung bestehend aus
0,2 g $Na_2PdCl_4$
0,8 g 1,4,7,10,13-Pentaoxycyclo dodecan
1000 ml $CCl_3$-$CH_3$
bei RT nach Sprühverfahren partiell aktiviert und anschließend nach Beispiel 1 sensibilisiert bzw. nach Beispiel 2 metallisiert und getempert.

Man bekommt eine nach dem Volladditivverfahren hergestellte Leiterplatte mit einer Metallhaftung ≧ 25 N/inch. Die Metallauflage besteht problemlos den Lötbadtest.

Beispiel 6 a

Eine 150 x 150 x 2 mm glasfaserverstärkte PPS/PC-Platte, (80 % PPS) wird 15 Min. in einem Bad bestehend aus
1000 ml $CF_3COOH$
750 ml $H_2O_2$
behandelt, mit $H_2O_{dest.}$ gewaschen, getrocknet,
in einem Bad bestehend aus
1000 ml Ethanol
2 g $AlCl_3$
1 g Bisbenzonitrilpalladium-II-chlorid
5 Min. aktiviert, mit $H_2O_{dest.}$ gewaschen und dann in einem chemischen Verkupferungsbad der Fa. Schering AG, D-1000 Berlin, mit einer 1 µm starker Cu-Auflage versehen, die Cu-Auflage auf galvanischem Wege auf 40 µm verstärkt und anschließend bei 170 °C 1 h getempert.

Man bekommt eine Verbundplatte mit einer sehr guten Metallhaftung.

Beispiel 7 a

Eine 300 x 100 x 3 mm glasfaserverstärke PPS/PC-Platte, (90 %PPS) wird wie in Beispiel 6 a oxidativ behandelt, aktiviert und metallisiert bzw. die Metallauflage mit galvanischem Ni auf 40 µm verstärkt und anschließend bei 135 °C 90 Minuten getempert. Man bekommt eine Verbundplatte mit sehr guter Metallhaftung und Kriechstromfestigkeit.

Beispiel 1 b

Eine spritzgegossene Kunststoffplatte, bestehend aus 85 Gew.-% PPS und 15 Gew.-% PA-6 (100 x 100 x 2 mm) der Fa. Bayer AG, 5090 Leverkusen 1, wird in einem Bad, bestehend aus
8,5 g $Na_2Cr_2O_7$ und
1000 ml $H_2SO_4$ ($\rho$ = 1,84 g/cm$^3$)
bei RT 5 Min. vorbehandelt, mit $H_2O_{dest.}$ gewaschen, getrocknet, in einer Lösung bestehend aus
0,5 g Mesityloxidpalladiumchlorid
1000 ml $CCl_2 = CCl_2$
bei RT 5 Min. aktiviert, getrocknet,
in einer Lösung bestehend aus
1,0 g NaOH, 8,0 g DMAB (Dimethylaminboran)

1000 ml $H_2O_{dest.}$ sensibilisiert,
mit $H_2O_{dest.}$ gewaschen und dann in einem Ni-Bad der Schering AG, 1000 Berlin, im Verlaufe von 30 Min. mit einer Ni-Auflage versehen. Anschließend wird diese Platte bei 150° C 1h getempert.

Man bekommt einen Verbundwerkstoff mit guter Metallhaftung. Die Haftfestigkeit der Metallauflage, bestimmt durch die Abzugskraft nach DIN 53 496, beträgt ≧ 30 N/25 mm.

Die galvanische Verstärkung von der o.a. PPS-Platte für die Bestimmung der Abzugskraft wurde wie folgt durchgeführt:

a) eine halbe Minute dekapieren in 10 %iger $H_2SO_4$
b) Spülen
c) 5 Minuten im Halbglanznickelbad, Spannung 3 Volt, Badtemperatur 60° C
d) Spülen
e) eine halbe Minute dekapieren,
f) 90 Minuten im Kupferbad, Spannung 1,3 Volt, Badtemperatur 28° C
g) Spülen.

Die Metallauflage besteht den Lötbadtest.

Die so hergestellte Platte wird mit einer partiellen Maske (Siebdruckverfahren) versehen, die maskenfreien Stellen auf galvanischem Wege auf 40 µm verstärkt, die Maske in $CH_2Cl_2$ von der PPS-Oberfläche entfernt und dann die restliche Ni-Auflage in einem Bad bestehend aus
3 g $FeCl_2$
15 ml HCl
500 ml $H_2O_{dest.}$
durch Differenzätzen von der Oberfläche entfernt. Man bekommt eine spritzgegossene Leiterplatte mit hervorragenden elektrischen und thermischen Eigenschaften, wie Kriechstromfestigkeit und Biegefestigkeit.

Die Platte besteht hervorragend den herkömmlichen Lötbadtest.

## Beispiel 2 b

Eine spritzgegossene Kunststoffplatte, bestehend aus 85 Gew.-% PA-6,6 wird in einem Bad, bestehend aus
1000 g $H_2SO_4$ ($\rho$ 1,84 g/cm$^3$)
100 g $H_2O_{dest.}$
bei 40° C 7,5 min vorbehandelt.

Aktivieren, Aufbringen der elektrisch leitenden Metallauflage bzw. Entwickeln der Leiterbahnen wird analog Beispiel 1 b vorgenommen.

Man bekommt eine spritzgegossene 3D-Schaltung mit hervorragender Kriechstromfestigkeit und Lötbadbeständigkeit. Die Abzugsbefestigung der Metalauflage beträgt ca. 37 N/25 mm

## Beispiel 3 b

Eine im Beispiel 1 b angegebene Kunststoff-Platte, die zusätzlich noch 10 Gew.-% $CaCO_3$ enthält, wird in einer Lösung bestehend aus

250 ml $CF_3-C(=O)-O-OH$
100 ml $H_2O_{dest.}$

bei RT im Verlaufe von 5 Minuten vorbehandelt, mit $H_2O_{dest.}$ gewaschen, in einem Bad bestehend aus
1,0 g Bisbenzonitrilpalladiumdichlorid
1000 ml $CH_3-C(=O)-CH_3$
aktiviert, getrocknet und dann nach Beispiel 1 b sensibilisiert.

Anschließend wird die Platte in einem handelsüblichen Cu-Bad der Shiplay AG, D-7000 Stuttgart, im Verlaufe von 50 Minuten verkupfert. Anschließend wird die Platte nach Beispiel 1 mit Hilfe eines Photoresists der Fa. BASF AG, nach dem Differenzverfahren mit Leiterbahnen versehen. Die anschließend bei

170° C getemperte Platte weist eine Metallhaftung von ≧ 30 N/inch auf. Die Metallauflage haftet auf der PPS-Oberfläche so gut, daß sie den Lötbadtest besteht.

Die Kriechstromfestigkeit ist hervorragend.

Beispiel 4 b

Eine 15 % glasfaserverstärkte PPS-PA-6,6-Platte (elastomermodifizierter Typ der Bayer AG, 5090 Leverkusen, mit 90%igen PPS-Anteil, bezogen auf die Kunststoffmasse), die noch zusätzlich $CaCO_3$ 10 % enthält, wird in einer Lösung, bestehend aus

5 g $CrO_3$

1000 ml $H_2SO_4$ ($\rho$ = 1,84 g/cm$^3$)

5 Minuten bei RT vorbehandelt, in einem kolloidalen Aktivator der Fa. Blasberg AG, in D-5650 Solingen, aktiviert und dann nach Beispiel 2 metallisiert bzw. mit Leiterbahnen versehen. Man bekommt eine Leiterplatte mit guter Metallhaftung (≧ 27,5 N/inch). Die Leiterbahnen bestehen den Lötbadtest.

Diese Platte zeichnet sich durch ihre hervorragende Kriechstromfestigkeit aus.

Beispiel 5 b

Eine herkömmliche, 15 % glasfaserverstärkte PPS-Ultemplatte mit 70 %igem PPS-Anteil wird in einer Lösung bestehend aus

5 g $CrO_3$

1000 ml $H_2SO_4$ ($\rho$ = 1,84 g/cm$^3$ )

5 Minuten bei 80° C vorbehandelt, in einem kolloidalen Aktivator der Fa. Blasberg AG, in D-5650 Solingen, aktiviert und dann nach Beispiel 2 b metallisiert bzw. mit Leiterbahnen versehen. Man bekommt eine Leiterplatte mit guter Metallhaftung (≧ 25 N/inch). Die Leiterbahnen bestehen den Lötbadtest. Die Platte weist hervorragende Kriechstromfestigkeit auf.

Beispiel 6 b

Eine 45 % glasfaserverstärkte PPS-Blend mit 10%igen PA-11-Anteil wird in einem Bad, bestehend aus

2 g $Br_2$

1000 ml $H_2O_{dest.}$

vorbehandelt, gewaschen und dann mit einem ionogenen Aktivator bestehend aus

1 g $PdCl_2$

10 g HCl (37 %ig)

1000 ml $H_2O_{dest.}$

aktiviert, nach Beispiel 1 b sensibilisiert. Diese Platte wird anschließend mit einer partiellen Maske (Siebdruckverfahren) versehen, in einem chemischen Metallisierungsbad mit 15 µm Cu-Auflage versehen und anschließend bei 160° C 1 Stunde getempert.

Man bekommt eine nach dem Volladditivverfahren hergestellte Leiterplatte mit einer guten Metallhaftfestigkeit. Diese Leiterplatte läßt sich in gängigen Lötbädern bei etwa 260° C löten.

Beispiel 7 b

Eine Leiterplatte nach Beispiel 1 b wird in einem Bad bestehend aus

5 g $Na_2Cr_2O_7$

600 g $H_2SO_{4konz.}$

150 g $H_3PO_{4konz.}$

vorbehandelt, gewaschen und getrocknet mit einer Aktivierungslösung bestehend aus

0,2 g $Na_2PdCl_4$

0,8 g 1,4,7,10,13-Pentaoxycyclododecan

1000 ml $CCl_3$-$CH_3$

bei RT nach Sprühverfahren partiell aktiviert und anschließend nach Beispiel 1 b sensibilisiert bzw. nach Beispiel 2 metallisiert und getempert.

Man bekommt eine nach dem Volladditivverfahren hergestellte Leiterplatte mit einer Metallhaftung ≧ 30 N/inch. Die Metallauflage besteht problemlos den Lötbadtest. Die Platte zeichnet sich durch ihre hervorragende Kriechstromfestigkeit und geringe Wasseraufnahme aus.

Beispiel 8 b

Eine 300 x 100 x 3 mm große Platte, bestehend aus 30 Gew.-% Glasfaser (3 mm) und PPS-PA.6-Blend (85 % PPS mit der mittleren Molmasse 25 000 mit -COOH-Endgruppen) wird 15 min in einem Bad bestehend aus
1000 ml $CF_3COOH$
750 ml $H_2O_2$
behandelt mit $H_2O_{dest.}$ gewaschen, getrocknet,
in einem Bad bestehend aus
1 g Bisbenzonitrilpalladium-II-chlorid
1000 ml $CH_2Cl_2$
5 Min. aktiviert, mit $H_2O_{dest.}$ gewaschen und dann in einem chemischen Verkupferungsbad der Fa. Schering AG, D-1000 Berlin, mit einer 1 µm starker Cu-Auflage versehen, die Cu-Auflage auf galvanischem Wege auf 40 µm verstärkt und anschließend bei 170 °C 1 h getempert.

Man bekommt eine Verbundplatte mit einer sehr guten Metallhaftung. Sie zeichnet sich durch überraschend gute Kriechstromfestigkeit und elektrischen Widerstand aus.

Beispiel 9 b

Eine 300 x 100 x 3 mm große PPS-PA-Blendplatte nach Beispiel 1 b, die zusätzliche 5 Gew.-% $CaCO_3$, 10 Gew.-% Glasfasern (3 mm) enthält, wird wie in Beispiel 6 b oxidativ behandelt, aktiviert und metallisiert bzw. die Metallauflage mit galvanischem Ni auf 40 µm verstärkt und anschließend bei 135 °C 90 Minuten getempert. Man bekommt eine Verbundplatte mit sehr guter Metallhaftung.

Beispiel 10 b

Eine 300 x 100 x 3 mm große PPS-APEC-Platte (vgl. hierzu Produktbeschreibung der Bayer AG, Bestell-Nr. KU 96 277, Ausgabe 7 : 8 D 1-877/846994) mit 85 gew.-prozentigem PPS-Anteil wird nach Beispiel 1 b vorbehandelt und anschließend mit einer Metallauflage versehen. Man bekommt eine Verbundplatte mit einer sehr guten Metallhaftung, die den Lötbadtest - 10 sec. bei 260 °C im konventionellen Lötbad - problemlos besteht.

Beispiel 11 b

Eine spritzgegossene Kunststoffplatte, bestehend aus 85 Gew.-% PPS und 15 Gew.-% Polyester auf Basis von Adipinsäure und Butandiol der Fa. Bayer AG, 5090 Leverkusen 1, wird nach Beispiel 1 b metallisiert. Man bekommt einen Verbundwerkstoff mit einer guten Metallhaftung > 30 N/inch. Diese Probe besteht problemlos den Lötbadtest.

Beispiel 1 c

Eine spritzgegossene PPS-Kautschuk-Blend-Platte (85 % PPS mit 15 % Kautschuk auf Basis van Polyisopren) (150x150x2 mm) wird in einem Bad, bestehend aus
7,0 g $Na_2Cr_2O_7$ und
1000 ml $H_2SO_4$ ($\rho$ = 1,84 g/cm³)
bei RT 5 Min. vorbehandelt, mit $H_2O$ dest. gewaschen, getrocknet, in einer Lösung, bestehend aus
0,5 g Mesityloxidpalladiumchlorid
1000 ml $CCl_2 = CCl_2$
bei RT 5 Min. aktiviert, getrocknet, in einer Lösung, bestehend aus

1,0 g NaOH,
8,0 g DMAB (Dimethylaminboran)
1000 ml $H_2O$ dest. sensibilisiert,
mit $H_2O$ dest. gewaschen und dann in einem Ni-Bad der Schering AG, 1000 Berlin, im Verlaufe von 30 Min. mit einer Ni-Auflage versehen.

Man bekommt einen Verbundwerkstoff mit guter Metallhaftung. Die Haftfestigkeit der Metallauflage, bestimmt durch die Abzugskraft nach DIN 53 496, beträgt ≧ 25 N/25 mm.

Die galvanische Verstärkung von der o.a. PPS-Kautschuk-Blend-Platte für die Bestimmung der Abzugskraft wurde wie folgt durchgeführt:

a) eine halbe Minute dekapieren in 10 %iger $H_2SO_4$
b) Spülen
c) 5 Minuten im Halbglanznickelbad, Spannung 3 Volt, Badtemperatur 60 °C
d) Spülen
e) eine halbe Minute dekapieren,
f) 90 Minuten im Kupferbad, Spannung 1,3 Volt, Badtemperatur 28 °C
g) Spülen.

Die Metallauflage besteht den Lötbadtest.

Die so hergestellte Platte wird mit einer partiellen Maske (Siebdruckverfahren) versehen, die maskenfreien Stellen auf galvanischem Wege auf 40 µm verstärkt, die Maske in $CH_2Cl_2$ von der Blend-Oberfläche entfernt und dann die restliche Ni-Auflage in einem Bad, bestehend aus
3 g $FeCl_2$
15 ml HCl
500 ml $H_2O$ dest.
durch Differenzätzen von der Oberfläche entfernt. Man bekommt eine spritzgegossene Leiterplatte mit hervorragenden elektrischen und thermischen Eigenschaften wie Kriechstromfestigkeit und Biegefestigkeit.

Diese Platte besteht hervorragend den herkömmlichen Lötbadtest problemlos.

## Beispiel 2 c

Eine im Beispiel 1 c angegebene Kunststoff-Platte, die zusätzlich noch 10 Gew.-% $TiO_2$ enthält, wird in einer Lösung, bestehend aus
250 ml $CF_3-\overset{O}{\overset{||}{C}}-O-OH$
100 ml $H_2O$ dest.
bei RT im Verlaufe von 5 Minuten vorbehandelt, mit $H_2O$ dest., gewaschen, in einem Bad, bestehend aus
1,0 g Bisbenzonitrilpalladiumdichlorid
1000 ml $CH_3-\underset{O}{\underset{||}{C}}-CH_3$
aktiviert, getrocknet und dann nach Beispiel 1 sensibilisiert.

Anschließend wird die Platte in einem handelsüblichen Cu-Bad der Shiplay AG, D-7000 Stuttgart, im Verlauf von 50 Minuten verkupfert. Anschließend wird die Platte nach Beispiel 1 mit Hilfe eines Photoresists der Fa. BASF AG, nach dem Differenzverfahren mit Leiterbahnen versehen. Die Platte weist eine Metallhaftung von ≧ 25 N/inch auf.

Die Metallauflage haftet auf der Platten-Oberfläche so gut, daß sie den Lötbadtest besteht.

Die Kriechstromfestigkeit dieser Platte ist gut.

## Beispiel 3 c

Eine 15 % glasfaserverstärkte PPS-PC-Platte mit 80 %igem PPS-Anteil (bezogen auf die Kunststoffmasse), die noch zusätzlich $MgCO_3$ 10 % enthält, wird in einer Lösung, bestehend aus
5 g $CrO_3$
1000 ml $H_2SO_4$ ($\rho$ = 1,84 g/cm$^3$)
5 Minuten bei 80 °C vorbehandelt, in einem kolloidalen Aktivator der Fa. Blasberg AG, D-5650 Solingen, aktiviert und dann nach Beispiel 2 c metallisiert bzw. mit Leiterbahnen versehen. Man bekommt eine Leiterplatte mit guter Metallhaftung (≧ 27,5 N/inch). Die Leiterbahnen bestehen den Lötbadtest.

Das hierzu eingesetzte Kautschuk ist ein vernetztes Pfropfcopolymerisat auf Basis von 1,4-Butadien und

Acrylnitril. Seine Acrylnitrilmenge beträgt ~20 Gew.-%.

Beispiel 4 c

Eine 20 % glasfaserverstärke kautschukmodifizierte PPS-Platte (83 % PPS und 17 % kautschukhaltiger Blendtyp) wird in einem Bad, bestehend aus

7 g $Na_2Cr_2O_7$
100 g $H_3PO_4$ ($\rho$ = 1,34 g/cm$^3$)
180 g $H_2SO_4$ ($\rho$ = 1,84 g/cm$^3$)
780 g $H_2O_{dest.}$

vorbehandelt, gewaschen und dann mit einem ionogenen Aktivator, bestehend aus

1 g $PdCl_2$
10 g HCl (37 %ig)
1000 ml $H_2O$ dest.

aktiviert, nach Beispiel 1 c sensibilisiert. Diese Platte wird anschließend mit einer partiellen Maske (Siebdruckverfahren) versehen, in einem chemischen Metallisierungsbad mit 15 µm Cu-Auflage versehen.

Man bekommt eine nach dem Volladditivverfahren hergestellte Leiterplatte mit einer guten Metallhaftung und Kriechstromfestigkeit. Diese Leiterplatte läßt sich in gängigen Lötbädern bei etwa 260°C löten. Das hierzu eingesetzte Kautschuk ist ein Pfropfcopolymerisat auf Basis von vernetztem 1,4-Polyisopren und Acrylsäuremethylester.

Beispiel 5 c

Eine Leiterplatte nach Beispiel 1 c wird in einem Bad, bestehend aus

5 g $Na_2Cr_2O_7$
100 g $H_2SO_4$ konz.
150 g $H_3PO_4$ konz.
750 g $H_2O$ dest.

bei 65°C 15 Min. vorbehandelt, gewaschen und getrocknet mit einer Aktivierungslösung, bestehend aus

0,2 g $Na_2PdCl_4$
0,8 g 1,4,7,10,13-Pentaoxycyclo-dodecan
1000 ml $CCl_3$-$CH_3$

bei RT nach Sprühverfahren partiell aktiviert und anschließend nach Beispiel 1 c sensibilisiert bzw. nach Beispiel 2 metallisiert und getempert.

Man bekommt eine nach dem Volladditivverfahren hergestellte Leiterplatte mit einer Metallhaftung ≧ 35 N/inch und einer hervorragenden Kriechstromfestigkeit. Die Metallauflage besteht problemlos den Lötbadtest.

Beispiel 6 c

Eine 150x150x2 mm große Kautschuk-modifizierte PPS-Platte, bestehend aus 60 Gew.-% PPS, 20 Gew.-% Kautschuk und 20 Gew.-% Glasfaser (3 mm) und PPS der mittleren Molmasse 25.000 mit -COOH Endgruppen wird 15 Min. in einem Bad, bestehend aus

1000 ml $CF_3COOH$
750 ml $H_2O_2$

behandelt, mit $H_2O$ dest. gewaschen, getrocknet, in einem Bad, bestehend aus

1000 ml Ethanol
2 g $AlCl_3$
1 g Bisbenzonitrilpalladium-II-chlorid

5 Min. aktiviert, mit $H_2O$ dest. gewaschen und dann in einem chemischen Verkupferungsbad der Fa. Schering AG, D-1000 Berlin, mit einer 1 µm starken Cu-Auflage versehen, die Cu-Auflage auf galvanischem Wege auf 40 µm verstärkt und anschließend bei 170°C 1 h getempert.

Man bekommt eine Verbundplatte mit einer sehr guten Metallhaftung.

## Ansprüche

1. Verfahren zur naßchemischen Metallisierung von Formkörpern aus Polyarylensulfiden, dadurch gekennzeichnet, daß man auf die Formkörper vor der Aktivierung ein Glas nicht-ätzendes Oxidationsmittel einwirken läßt und daß die Formkörper aus solchen Polyarylensulfiden bestehen, die
a) 3 - 40% Polycarbonat oder Polyarylether,
b) 2,5 - 15% Polyamid oder Polyester,
c) 2 - 20% eines Kautschukelastomeren - jeweils bezogen auf das Gesamtgewicht der Polymermischung -enthalten,
wobei im Falle von a) und b) mit $TiO_2$ und $MgCO_3$ gefüllte Formmassen ausgenommen sind.

2. Verfahren nach Anspruch 1, dadurch gekennzeichnet, daß der Gewichtsanteil Polycarbonat bzw. Polyarylether 5 - 10 % beträgt.

3. Verfahren nach Anspruch 1, dadurch gekennzeichnet, daß der Gewichtsanteil Polyamid bzw. Polyester 5 bis 10% beträgt.

4. Verfahren nach Anspruch 1, dadurch gekennzeichnet, daß der Gewichtsanteil des Kautschuks 3 bis 10% beträgt.

5. Verfahren nach Anspruch 1, dadurch gekennzeichnet, daß die Aktivierung mit metallorganischen Komplexverbindungen durchgeführt wird.

6. Verfahren nach Anspruch 1, dadurch gekennzeichnet, daß als Oxidationsmittel Bromlösungen, konz. Schwefelsäure oder Chromschwefelsäure oder deren Gemische mit Phosphorsäure oder organische Persäuren eingesetzt werden.

7. Verfahren gemäß Anspruch 1, dadurch gekennzeichnet, daß die Formkörper zum Aufbau von elektrischen Leiterplatten nach der Additiv- oder Semiadditivmethode partiell metallisiert werden.

8. Leiterplatten erhalten gemäß Verfahren des Anspruchs 7.